(19) Europäisches Patentamt
European Patent Office
Office européen des brevets

(11) EP 4 538 754 A1

(12) **EUROPEAN PATENT APPLICATION**
published in accordance with Art. 153(4) EPC

(43) Date of publication:
**16.04.2025 Bulletin 2025/16**

(21) Application number: **23843314.8**

(22) Date of filing: **18.07.2023**

(51) International Patent Classification (IPC):
***G02B 5/20*** *(2006.01)* ***C08J 5/18*** *(2006.01)*
***C08K 7/02*** *(2006.01)* ***G09F 9/30*** *(2006.01)*
***H10K 59/00*** *(2023.01)* ***G02F 1/1335*** *(2006.01)*
***G09F 9/00*** *(2006.01)* ***H10K 50/00*** *(2023.01)*

(52) Cooperative Patent Classification (CPC):
**C08J 5/18; C08K 7/02; G02B 5/20; G02F 1/1335; G09F 9/00; G09F 9/30; H10K 50/00; H10K 59/00**

(86) International application number:
**PCT/KR2023/010253**

(87) International publication number:
**WO 2024/019468 (25.01.2024 Gazette 2024/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.07.2022 KR 20220088348**
**17.07.2023 KR 20230092480**

(71) Applicant: **Kolon Industries, Inc.**
**Seoul 07793 (KR)**

(72) Inventors:
- **KWON, Kyung Wook**
  **Seoul 07793 (KR)**
- **KIM, Han Sol**
  **Seoul 07793 (KR)**
- **SHIN, In Ho**
  **Seoul 07793 (KR)**
- **PARK, Hyo Jun**
  **Seoul 07793 (KR)**
- **YANG, Jong Won**
  **Seoul 07793 (KR)**
- **PARK, Jae Heung**
  **Seoul 07793 (KR)**

(74) Representative: **Ter Meer Steinmeister & Partner**
**Patentanwälte mbB**
**Nymphenburger Straße 4**
**80335 München (DE)**

(54) **OPTICAL FILM AND DISPLAY DEVICE INCLUDING SAME**

(57) An embodiment of the present invention provides an optical film and a display device including same, the optical film comprising: a light-transmissive matrix; and a filler dispersed in the light-transmissive matrix, wherein the filler has a fiber shape, and when A denotes the diameter of the filler and B denotes the length of the filler, B/A ranges from 10 to 500.

FIG. 1

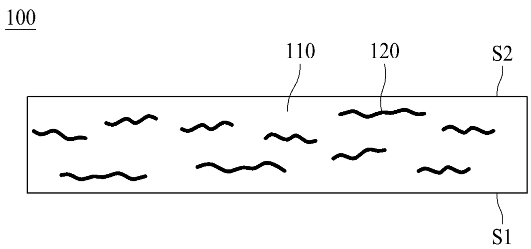

## Description

[Technical Field]

The present disclosure relates to an optical film and a display device including the same and more particularly, to an optical film having excellent mechanical properties.

[Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

Fillers may be added in order to impart desired physical properties to an optical film requiring various physical properties. The fillers may vary depending on physical properties required of the optical film.

[Disclosure]

[Technical Problem]

Therefore, the present disclosure has been made in view of the above problems, and it is one aspect of the present disclosure to provide an optical film that includes a fiber-shape or filament-shape filler dispersed in a light-transmitting matrix.

It is another aspect of the present disclosure to provide an optical film that includes a fiber-shape or filament-shape filler dispersed in a light-transmitting matrix, wherein the fiber-shape or filament-shape filler engages polymer chains constituting the light-transmitting matrix, to improve the stability and alignment characteristics of the polymer chains.

It is another aspect of the present disclosure to provide an optical film that includes a fiber-shape or filament-shape filler dispersed in a light-transmitting matrix, to provide excellent modulus.

It is another aspect of the present disclosure to provide a display device including the optical film.

[Technical Solution]

In accordance with one aspect of the present disclosure, provided is an optical film including a light-transmitting matrix and a filler dispersed in the light-transmitting matrix, wherein the filler has a fiber-shape and has a ratio of B/A of 10 to 500 wherein A represents a diameter of the filler and B represents a length of the filler.

In accordance with another aspect of the present disclosure, provided is an optical film including a filler having a degree of machine direction (MD) orientation of 60 to 90%.

In accordance with another aspect of the present disclosure, provided is a method of manufacturing an optical film including primarily dispersing a filler and improving the arrangement of the filler.

In accordance with another aspect of the present disclosure, provided is a display device including a display panel and the optical film disposed on the display panel.

[Advantageous Effects]

According to one embodiment of the present disclosure, the filler included in the optical film has a fiber-shape or filament-shape and may engage polymer chains constituting the light-transmitting matrix. As a result, mechanical strength, and in particular, modulus of the optical film may be improved.

According to one embodiment of the present disclosure, an optical film including a fiber-shape or filament-shape filler may have excellent mechanical properties as well as excellent optical properties. The optical film according to an embodiment of the present disclosure has excellent optical and mechanical properties, thus being useful as a cover window of a display device.

[Description of Drawings]

FIG. 1 is a schematic diagram illustrating an optical film according to an embodiment of the present disclosure.

FIG. 2 is a cross-sectional view illustrating a part of a display device according to another exemplary embodiment of the present disclosure.

FIG. 3 is an enlarged cross-sectional view illustrating part "P" in FIG. 2.

FIG. 4 is an example of an FT-IR graph of an optical film according to an embodiment of the present disclosure.

[Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, even if there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

FIG. 1 is a schematic diagram illustrating an optical film 100 according to an embodiment of the present disclosure. According to one embodiment of the present disclosure, a film having light transmittance is referred to as an "optical film 100".

According to an embodiment of the present disclosure, the optical film 100 may have a first surface S1 and a second surface S2 that face each other.

For example, when the optical film 100 is manufactured by a casting method, a surface of the optical film 100 that contacts a casting substrate may be referred to as a "belt surface". According to an embodiment of the present disclosure, the belt surface of the optical film 100 is referred to as a "first surface S1". In addition, the optical film 100 may have a surface facing the belt surface, and the surface of the optical film 100 facing the belt surface may be referred to as an "air surface". According to one embodiment of the present disclosure, the air surface of the optical film 100 is referred to as a "second

surface S2".

The optical film 100 according to an embodiment of the present disclosure includes a light-transmitting matrix 110 and a filler 120 dispersed in the light-transmitting matrix 110.

According to an embodiment of the present disclosure, the light-transmitting matrix 110 may be flexible. For example, the optical film according to an embodiment of the present disclosure may be bendable, foldable, or rollable. As a result, the optical film according to an embodiment of the present disclosure may be light-transmissive and may be bendable, foldable, or rollable.

According to an embodiment of the present disclosure, the light-transmitting matrix 110 may include at least one of an imide repeating unit and an amide repeating unit.

The light-transmitting matrix 110 according to an embodiment of the present disclosure may be produced from monomeric ingredients including dianhydrides and diamines. Specifically, the light-transmitting matrix 110 may include an imide repeating unit formed by dianhydride and diamine.

However, the light-transmitting matrix 110 according to an embodiment of the present disclosure is not limited thereto, and the light-transmitting matrix 110 may be produced from monomeric ingredients including a dicarbonyl compound in addition to dianhydride and diamine. The light-transmitting matrix 110 according to an embodiment of the present disclosure may have an imide repeating unit and an amide repeating unit. For example, the light-transmitting matrix 110 having an imide repeating unit and an amide repeating unit may be a polyamide-imide resin.

According to one embodiment of the present disclosure, the light-transmitting matrix 110 may include a polyimide-based polymer. Examples of the polyimide-based polymer may include polyimide polymers, polyamide polymers, polyamide-imide polymers and the like. The light-transmitting matrix 110 according to an embodiment of the present disclosure may be formed of, for example, a polyimide-based polymer resin.

The light-transmitting matrix 110 may have a thickness sufficient for the optical film 100 to protect the display panel. For example, the light-transmitting matrix 110 may have a thickness of 10 to 100 $\mu$m. The thickness of the light-transmitting matrix 110 may be the same as that of the optical film 100.

According to one embodiment of the present disclosure, the filler 120 may have a fiber-shape. For example, a fiber may refer to a material that is much longer in length than in diameter. The fiber may refer to a thin and long threadlike material. The fiber may refer to a material having a linear structure. The fiber may also refer to a long and bendable material.

Hereinafter, a shape having a length greater than a diameter is referred to as a "fiber-shape". The fiber-shape may also be referred to as a "filament-shape". According to one embodiment of the present disclosure, the length of the filler 120 may be two or more times the diameter.

According to one embodiment of the present disclosure, the filler 120 is aligned in parallel to the polymer chain of the polymer resin, or aligned alongsided with the polymer chain of the polymer resin included in the light-transmitting matrix 110. For example, the filler 120 may be bonded to the main chain of a polymer resin through a secondary bond such as a hydrogen bond or a dipole moment-based bond, and may be aligned in parallel to the polymer resin in a main chain direction.

According to one embodiment of the present disclosure, the filler 120 has a fiber-shape so that polymer chains constituting the light-transmitting matrix 110 can be engaged (or linked, or connected) with each other. As a result, the stability and alignment characteristics of the polymer chains are improved, so that the mechanical properties of the light-transmitting matrix 110 may be improved and the mechanical properties of the optical film 100 may also be improved.

According to one embodiment of the present disclosure, when the diameter of the filler 120 is defined as "A" and the length of the filler 120 is defined as "B", the ratio of B/A may be in the range of 10 to 500.

When the ratio (B/A) of the length to the diameter of the filler 120 is less than 10, the filler 120 is not long enough and thus does not sufficiently exert the function of engaging polymer chains and the effects of improving stability and alignment characteristics of the polymer chains.

When the ratio (B/A) of the length to the diameter of the filler 120 is higher than 500, the filler 120 is excessively long, thus causing deterioration in dispersibility and aggregation in the light-transmitting matrix 110. As a result, the optical film 100 may have decreased light transmittance, increased haze, and deteriorated optical properties. In addition, the mechanical strength of the optical film 100 may be lowered in the portion where the aggregation of the filler 120 occurs, thus leading to deterioration in the modulus and mechanical properties of the optical film 100.

According to one embodiment of the present disclosure, the ratio (B/A) of the length to the diameter of the filler 120 may be, for example, in the range of 50 to 500. More specifically, the ratio (B/A) of the length to the diameter of the filler 120 may be, for example, in the range of 100 to 400, and may be in the range of 200 to 400. The ratio (B/A) of length to diameter of the filler 120 may be in the range of 300 to 400.

According to one embodiment of the present disclosure, when the ratio of the length to the diameter of the filler 120 is 100 or more, the modulus of the optical film 100 may be further improved. Meanwhile, when the ratio of the length to the diameter of the filler 120 is 400 or less, the modulus of the optical film 100 may be improved and deterioration in foldability may be prevented.

According to one embodiment of the present disclosure, the filler 120 may have a diameter of 2 nm to 10 nm and a

length of 200 nm to 4,000 nm.

According to one embodiment of the present disclosure, the diameter and length of the filler 120 may be measured by transmission electron microscopy (TEM).

When the diameter of the filler 120 is less than 2 nm, the stability of the filler 120 may be lowered, the filler 120 may be broken or crumble, and thus the optical film 100 may be contaminated and haze may be increased. When the diameter of the filler 120 is higher than 10 nm, it may be difficult for the filler 120 to have a fiber-shape, the function of the filler 120 engaging polymer chains may deteriorate, and the optical film 100 may have decreased transmittance.

When the length of the filler 120 is less than 200 nm, the function of the filler 120 engaging polymer chains may not be sufficiently obtained. When the length of the filler 120 is higher than 4,000 nm, the dispersibility of the filler 120 may decrease, thus causing aggregation of the filler 120 in the light-transmitting matrix 110. Accordingly, the optical film 100 may have decreased light transmittance, increased haze, and deteriorated optical properties.

According to one embodiment of the present disclosure, the length of the filler 120 may be controlled by growth conditions of the filler 120 or post-treatment of the filler 120. For example, the length of the filler 120 may be appropriately adjusted through temperature control during growth of the filler 120. In addition, ultrasonic wave or other energy may be applied to the filler 120 grown to a predetermined length so that the filler 120 can be cut to an appropriate length.

There is no particular limitation as to the type of the filler 120. Any filler may be used as the filler 120 according to one embodiment of the present disclosure without limitation to the type thereof so long as it has a fiber-shape. The filler 120 may be inorganic or organic. The filler 120 may include at least one of inorganic fibers, organic fibers, and organic-inorganic composite fibers.

More specifically, the filler 120 may have a fiber-shape. For example, the filler 120 may have a fiber-shape including one strand or multiple strands, or may have a shape in which a plurality of strands is branched in one central strand.

According to one embodiment of the present disclosure, the filler 120 may include at least one of glass fiber, aluminum fiber and fluoride fiber.

The glass fiber includes $SiO_2$ and may further include other components as well as $SiO_2$. The aluminum fiber includes $Al_2O_3$ and may further include other components as well as $Al_2O_3$. The fluoride fiber may include at least one of polytetrafluoroethylene (PTFE) and polyvinylidene fluoride (PVDF), and may further include other components as well as PTFE and PVDF.

According to an embodiment of the present disclosure, the filler 120 may include at least one of aluminum oxide hydroxide, $SiO_2$, $Al_2O_3$, polytetrafluoroethylene (PTFE), or polyvinylidene fluoride (PVDF).

According to one embodiment of the present disclosure, the filler 120 may be surface-treated. For example, the filler 120 may be a fiber surface-treated with an organic compound having an alkoxy group.

According to an embodiment of the present disclosure, the aluminum fiber may include at least one of aluminum oxide hydroxide and $Al_2O_3$. Aluminum oxide hydroxide is also called "Boehmite" and may be represented by $\gamma$-AlO(OH). More specifically, the aluminum oxide hydroxide may have a unit structure represented by Formula 1 below.

[Formula 1]

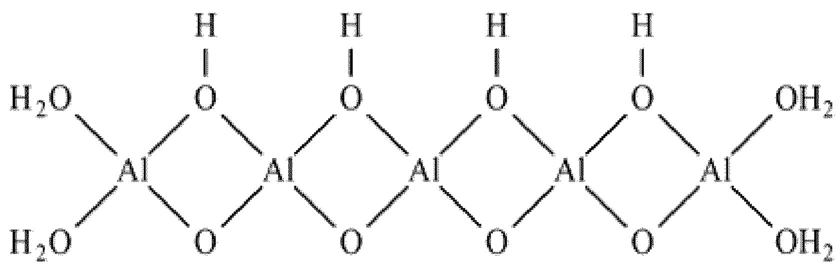

According to an embodiment of the present disclosure, $Al_2O_3$ may have a unit structure represented by Formula 2 below.

[Formula 2]

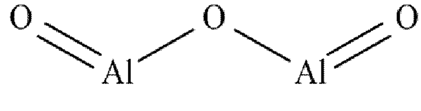

According to an embodiment of the present disclosure, $SiO_2$ may have a unit structure represented by Formula 3

below.

[Formula 3]

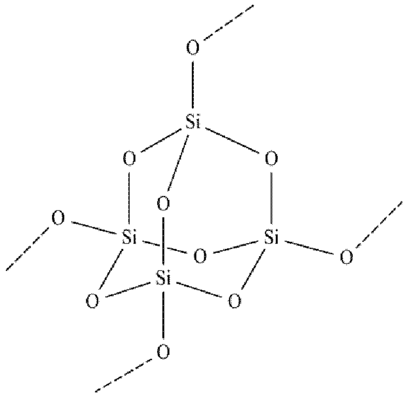

In addition, according to one embodiment of the present disclosure, the filler 120 may include a structure represented by any one of Formulas 4, 5, and 6 below.

[Formula 4]

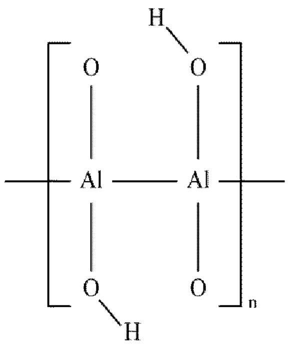

[Formula 5]

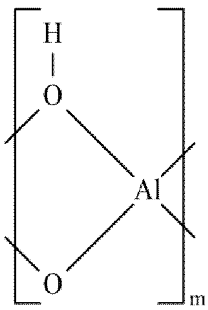

[Formula 6]

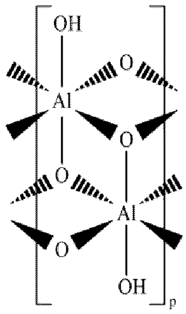

wherein n is in the range of 100 to 20,000, m is in the range of 50 to 10,000, and p is in the range of 50 to 10,000.

When the structures of Formulas 4, 5, and 6 are expanded for better understanding of the structure of the filler 120, the filler 120 may include structures represented by any one of Formulas 7, 8, and 9 below.

The structure represented by Formula 4 may be represented by, for example, Formula 7 below. The following Formula 7 corresponds to the structure of Formula 4 wherein n is 3.

[Formula 7]

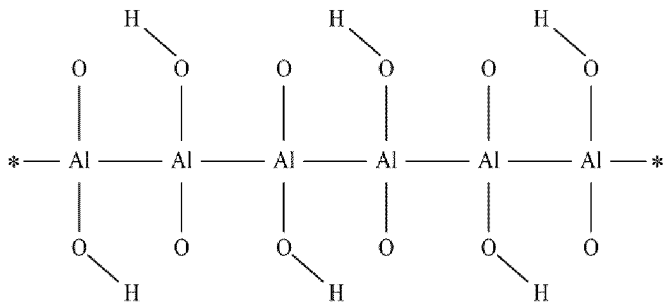

The structure represented by Formula 5 may be represented by, for example, Formula 8 below. The following Formula 8 corresponds to the structure of Formula 5 wherein m is 4.

[Formula 8]

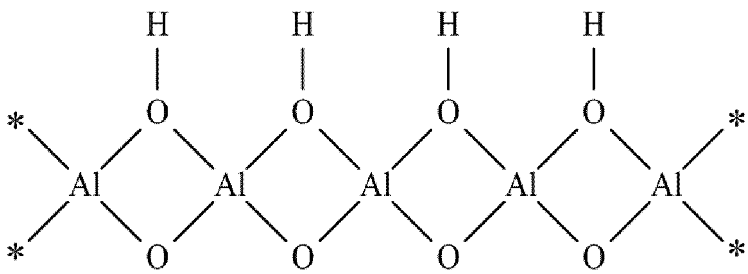

The structure represented by Formula 6 may be represented by, for example, Formula 9 below. The following Formula 9 corresponds to the structure of Formula 6 wherein p is 5.

[Formula 9]

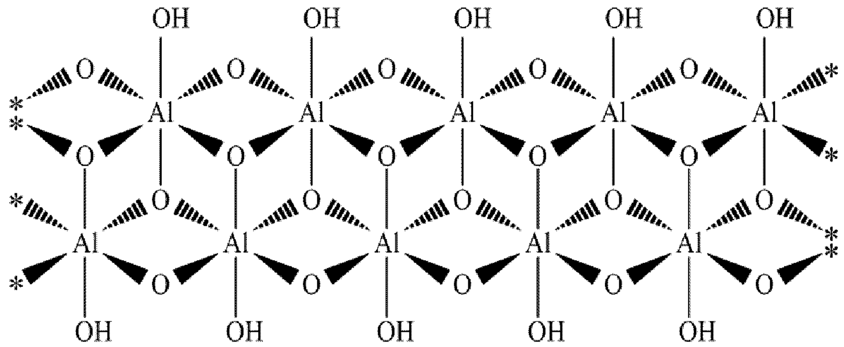

In Formulas 7 to 9, "*" represents a bonding site.

According to an embodiment of the present disclosure, when the filler 120 is added, it causes appropriate light scattering, thus improving the optical properties of the optical film 100. In order to enhance the light scattering effect, the content of the filler 120 in the optical film 100 may be adjusted.

According to one embodiment of the present disclosure, the content of the filler 120 may be in the range of 1 to 40% by weight with respect to the total weight of the optical film 100.

When the content of the filler 120 is less than 1% by weight with respect to the total weight of the optical film 100, the effect of improving the light transmittance of the optical film 100 may not be obtained due to insignificant light scattering effect by the filler 120 and the effect of improving the modulus of the optical film 100 may be insignificant since the function of the filler 120 to engage polymer chains together is not sufficiently obtained.

Meanwhile, when the content of the filler 120 is higher than 40% by weight based on the total weight of the optical film 100, the dispersibility of the filler 120 may be lowered, the haze of the optical film 100 may be lowered, the aggregation of the filler 120 may occur due to the excessive amount thereof, and the aggregated filler 120 may block light, thus decreasing light transmittance of the optical film 100.

More specifically, the content of the filler 120 with respect to the total weight of the optical film 100 may be adjusted to 3 to 40% by weight, 5 to 40% by weight, 5 to 30% by weight, or 5 to 20% by weight.

According to one embodiment of the present disclosure, an increase in haze and a decrease in light transmittance of the optical film 100 can be prevented, and the modulus and mechanical strength of the optical film 100 can be improved by controlling the diameter, length and content of the filler 120 and improving the dispersion method.

The optical film 100 according to an embodiment of the present disclosure may have a modulus of 6.3 GPa or more. More specifically, the optical film 100 according to an embodiment of the present disclosure may have a modulus of 6.3 GPa or more or 6.5 GPa or more, based on a sample size of 10 cm × 1 cm.

According to one embodiment of the present disclosure, the filler 120 has a fiber-shape so that polymer chains constituting the light-transmitting matrix 110 can be engaged with each other. As a result, stability and alignment characteristics of polymer chains are improved and intermolecular attraction is increased, so that the optical film 100 may have a large modulus of 6.3 GPa or more or 6.5 GPa or more.

In general, it is known that it is difficult for a film formed of a polymer resin to have a modulus of 6.0 GPa or more or 6.3 GPa or more. However, according to one embodiment of the present disclosure, although the fiber-shape filler 120 is used, a large modulus of 6.3 GPa or more can be imparted to the optical film 100 by controlling the diameter, the length, the ratio (B/A) of the diameter to the length, and the content ratio of the filler 120 dispersed in the light-transmitting matrix 110.

According to an embodiment of the present disclosure, the optical film 100 may have a machine direction (MD) and a transverse direction (TD).

The direction in which mechanical treatment is performed on the film is called "machine direction (MD)", and the direction perpendicular to the MD is called "transverse direction (TD)". For example, when the film is stretched, a direction parallel to the direction of stretching may be the machine direction (MD), when the film is cast, the direction parallel to the direction of casting may be the machine direction (MD), and when the film is wound through a roller, a direction parallel to the direction of winding may be the machine direction (MD).

According to one embodiment of the present disclosure, the machine direction (MD) is a direction parallel to the casting direction of the optical film 100 in the manufacturing process. The machine direction (MD) may also be referred to as a longitudinal direction. The TD is a direction perpendicular to the MD. The transverse direction (TD) may also be referred to as a "width direction".

According to an embodiment of the present disclosure, the ratio of Mm/Mt of the optical film 100 may be greater than 1, wherein "Mm" represents the modulus in the MD and "Mt" represents the modulus in the TD. This means that the

modulus in the MD is greater than the modulus in the TD.

According to one embodiment of the present disclosure, the orientation direction and degree of the filler 120 may be changed, for example, by adjusting the pressure applied to the cast film manufactured by casting, the air direction during drying, and the viscosity of the casting solution, in the manufacturing process of the optical film 100. As a result, the Mm/Mt of the optical film 100 may be changed.

According to one embodiment of the present disclosure, the Mm/Mt may be adjusted to a level greater than 1 by adjusting the orientation direction and degree of the filler 120 through control of the pressure applied to the cast film.

More specifically, according to an embodiment of the present disclosure, Mm/Mt may be 1.1 or more, Mm/Mt may be 1.25 or more, and Mm/Mt may be 2.5 or more. In this case, alignment characteristics of the filler 120 in the optical film 100 can be further improved. As a result, the modulus of the optical film 100 can be further improved.

According to one embodiment of the present disclosure, the filler 120 may have a degree of MD orientation of 60% to 90%.

The degree of the MD orientation of the filler 120 indicates the degree to which the filler 120 is oriented in the MD. According to an embodiment of the present disclosure, the degree of the MD orientation of the filler 120 is determined by the degree of light absorption resulting from the degree of MD orientation of the filler 120.

The degree of MD orientation of the filler 120 dispersed in the optical film 100 may be measured using an FT-IR spectrometer in accordance with the following apparatus and conditions.

(1) Device and measurement conditions

- FT-IR spectrometer: PerkinElmer spectrum 100
- Veemax III with ATR and 45 degree ZnSe crystal
- Incident angle: 80 degrees (air to crystal), polarization angle: 0 degrees

(2) Measurement of absorbance and correction value in MD

FT-IR in the MD of the optical film 100 is measured to measure the absorbance of the filler 120 in the MD. At this time, light polarized in the TD is irradiated to the optical film 100. Light polarized in the TD is irradiated to measure the absorbance of the filler 120 in the MD since the Al-O stretching direction of the filler 120 is perpendicular to the longitudinal direction of the filler 120.

FT-IR measurements in the MD of the optical film 100 are performed on the first surface (S1, belt surface) and the second surface (S2, air surface).

As a result, for example, an FT-IR graph as shown in FIG. 4 can be obtained.

$AlO_{MD}$ and $Ref_{MD}$ can be obtained from the measurement results and graphs.

$AlO_{MD}$ is defined as the difference between absorbance (A) at a wave number of 760 $cm^{-1}$ and the absorbance at a wave number of 869 $cm^{-1}$ as can be depicted in Equation 1 below.

[Equation 1]

$$AlO_{MD} = A(760\ cm^{-1}) - A(869\ cm^{-1});\ (MD)$$

$Ref_{MD}$ is defined as the area between the wave number of 1,509 $cm^{-1}$ and the wave number of 1,470 $cm^{-1}$ in the FT-IR graph (see FIG. 4). In FIG. 4, the shaded area between wave numbers 1,509 $cm^{-1}$ and 1,470 $cm^{-1}$ corresponds to $Ref_{MD}$.

In the FT-IR graph of the optical film 100 according to an embodiment of the present disclosure, the area between the wave number of 1,509 $cm^{-1}$ and the wave number of 1,470 $cm^{-1}$ is almost constant regardless of the content of filler, or presence or absence of filler. Therefore, in the FT-IR graph, the area between the wave number 1,509 $cm^{-1}$ and the wave number 1,470 $cm^{-1}$ is referred to as a "dummy area" and the dummy area is applied to correct the absorbance value.

Next, an absorbance correction value ($A_{MD}$) in the MD is obtained from the $AlO_{MD}$ calculated in Equation 1 and the $Ref_{MD}$ obtained from the FT-IR graph (see FIG. 4). The absorbance correction value in the MD is calculated in accordance with Equation 2 below. According to one embodiment of the present disclosure, $A_{MD}$ in Equation 2 is referred to as an "absorbance correction value in MD".

[Equation 2]

$$A_{MD} = AlO_{MD}/Ref_{MD}$$

(3) Measurement of absorbance and correction value in TD

FT-IR in the TD of the optical film 100 is measured to measure the absorbance of the filler 120 in the TD. At this time, light polarized in the MD is irradiated to the optical film 100. Light polarized in the MD is irradiated to measure the absorbance of the filler 120 in the TD since the Al-O stretching direction of the filler 120 is perpendicular to the longitudinal direction of the filler 120.

FT-IR measurements in the TD of the optical film 100 are performed on the first surface (S1, belt surface) and the second surface (S2, air surface).

As a result, for example, an FT-IR graph as shown in FIG. 4 can be obtained.

$AlO_{TD}$ and $Ref_{TD}$ can be obtained from the measurement results and graphs.

$AlO_{TD}$ is defined as the difference between the absorbance (A) at a wave number of 760 $cm^{-1}$ and the absorbance at a wave number of 869 $cm^{-1}$.

[Equation 3]

$$AlO_{TD} = A(760cm^{-1})-A(869cm^{-1});\ (TD)$$

$Ref_{TD}$ is defined as the area between the wave number of 1,509 $cm^{-1}$ and the wave number of 1,470 $cm^{-1}$ in the FT-IR graph (see FIG. 4). In FIG. 4, the shaded area between wave numbers of 1,509 $cm^{-1}$ and 1,470 $cm^{-1}$ corresponds to $Ref_{TD}$.

Next, an absorbance correction value ($A_{TD}$) in the TD is obtained from the $AlO_{TD}$ calculated in Equation 3 and the $Ref_{TD}$ obtained from the FT-IR graph (see FIG. 4). The absorbance correction value in the TD is calculated in accordance with Equation 4 below. According to one embodiment of the present disclosure, $A_{TD}$ in Equation 4 is referred to as "absorbance correction value in TD".

[Equation 4]

$$A_{TD} = AlO_{TD}/Ref_{TD}$$

(4) Degree of MD orientation

From the absorbance correction value ($A_{MD}$) in the MD calculated in Equation 2 and the absorbance correction value ($A_{TD}$) in the TD calculated in Equation 4, the degree of MD orientation of the optical film 100 is calculated in accordance with the following Equation 5.

[Equation 5]

$$\text{Degree of MD orientation (\%)} = [A_{MD} / (A_{MD} + A_{TD})] \times 100$$

When the degree of MD orientation of the filler 120 is less than 60%, the MD modulus of the optical film 100 may be insufficient. When the degree of MD orientation of the filler 120 is higher than 90%, the foldability of the optical film 100 may deteriorate.

According to one embodiment of the present disclosure, when the degree of MD orientation of the filler 120 is 60 to 90%, the deterioration in foldability can be prevented while a high modulus in the MD is obtained.

According to one embodiment of the present disclosure, excellent foldability can be obtained without fold marks even when the radius of curvature (R) is 2.0R.

Specifically, when the optical film 100 is folded, mechanical change of the film may occur. In the present disclosure, for example, the folding mark refers to a phenomenon in which the film is bent, the surface of the film is unevenly wrinkled, or a transparent film is whitened. In addition to wrinkling or whitening, a difference in length may occur before and after folding, or changes in mechanical and optical properties of the optical film 100, such as a difference in light transmittance, may occur.

The optical film 100 according to an embodiment of the present disclosure includes a fiber-shape filler 120 having

a ratio (B/A) of length to diameter within a predetermined range, thereby preventing deterioration in foldability and thus realizing excellent folding performance while obtaining a high modulus.

The optical film 100 according to an embodiment of the present disclosure may have a Vickers hardness (Hv) of 40 MPa or more. Since the fiber-shape filler 120 engages polymers, in particular, polymer chains constituting the light-transmitting matrix 110, so that a high Vickers hardness (Hv) of 40 MPa or more can be imparted to the optical film 100.

According to one embodiment of the present disclosure, the optical film 100 may have a yellowness index of 3 or less.

According to one embodiment of the present disclosure, even if the optical film 100 includes the filler 120 having a ratio of length to diameter (B/A) in the range of 10 to 500, the filler 120 is uniformly dispersed in the optical film 100 and has a degree of orientation within a certain range, so that the yellowness index of the optical film 100 is not greatly increased and the optical properties are not deteriorated. More specifically, the optical film 100 may include a filler 120 having a ratio of length to diameter (B/A) within the range of 100 to 400. Even in this case, the yellowness index of the optical film 100 is not greatly increased and the optical properties are not deteriorated.

According to one embodiment of the present disclosure, the optical film 100 may have a haze of 4% or less, and more specifically, may have a haze of 1% or less. Although the filler 120 included in the light-transmitting matrix 110 is relatively long, the diameter of the filler 120 is small, so an increase in haze caused by the filler 120 can be prevented. In particular, although the fiber-shape filler 120 is used, a haze of 4% or less, for example, a haze of 1% or less can be imparted to the optical film 100 by adjusting the diameter, length, and the ratio of length to diameter (B/A) and the content ratio of the filler 120 dispersed in the light-transmitting matrix 110, and improving the dispersibility of the filler 120.

Also, according to an embodiment of the present disclosure, the optical film 100 may have a light transmittance of 88% or more. Although the length of the fillers 120 included in the light-transmitting matrix 110 is relatively great, the diameter of the fillers 120 is small, so that decrease in light transmittance by the filler 120 can be prevented. In particular, although the fiber-shape filler 120 is used, a light transmittance of 88% or more can be imparted to the optical film 100 by adjusting the diameter, length, the ratio of length to diameter (B/A) and content ratio of the filler 120 dispersed in the light-transmitting matrix 110, and improving the dispersibility of the filler 120.

According to one embodiment of the present disclosure, the optical film 100 includes a fiber-shape filler 120, but does not have polarization characteristics. Therefore, polarization may not occur in the optical film 100.

In general, when the filler 120 included in the film is aligned (oriented) in a certain direction, polarization may occur. However, the filler 120 according to an embodiment of the present disclosure may have various orientation directions within the light-transmitting matrix 110. Therefore, even if the filler 120 has a degree of MD orientation of 60 to 90% in the light-transmitting matrix 110, the viewing angle of the optical film 100 may not deteriorate.

The optical film 100 according to an embodiment of the present disclosure has electrical insulating properties.

The fiber-shape filler 120 included in the optical film 100 may be, for example, an inorganic filler including a metal. According to one embodiment of the present disclosure, the filler included in the optical film 100 includes a metal, but is in the form of an oxide. Accordingly, the optical film 100 including the filler 120 may have electrical insulating properties.

The optical film 100 according to an embodiment of the present disclosure may have, for example, a sheet resistance of $1 \times 10^{10}$ Ω/□ or more. Therefore, the optical film 100 including the filler 120 has electrical insulating properties. More specifically, the optical film 100 according to an embodiment of the present disclosure may have a sheet resistance higher than $1 \times 10^{15}$ Ω/□.

Since the optical film 100 according to an embodiment of the present disclosure has excellent electrical insulating properties, it may not interfere with the function of, for example, a touch panel, when applied to the touch panel.

FIG. 2 is a cross-sectional view illustrating a part of a display device 200 according to another embodiment of the present disclosure and FIG. 3 is an enlarged cross-sectional view of "P" in FIG. 2.

Referring to FIG. 2, the display device 200 according to another embodiment of the present disclosure includes a display panel 501 and an optical film 100 on the display panel 501.

Referring to FIGs. 2 and 3, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGs. 2 and 3 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 3, a gate insulating layer 535 is disposed between the gate electrode 530 and the semiconductor layer 520. An interlayer insulating layer 551 may be disposed on the gate electrode 530, and a source electrode

541 and a drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed in the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above. The optical film 100 includes a light-transmitting matrix 110 and a filler 120 dispersed in the light-transmitting matrix 110.

Hereinafter, a method of manufacturing an optical film 100 according to another embodiment of the present disclosure will be described.

The method of manufacturing an optical film 100 according to an embodiment of the present disclosure includes primarily dispersing the filler 120 in a resin solution for forming a polymer matrix 110 to prepare a first mix solution, improving the alignment characteristics of the filler 120 in the first mixture solution, and casting the first mixture solution to produce a cast film.

According to one embodiment of the present disclosure, a polyimide-based resin solution may be used as the resin solution for forming the polymer matrix 110.

More specifically, the method of manufacturing the optical film 100 according to an embodiment of the present disclosure includes preparing a polyimide-based resin powder, dissolving the polyimide-based resin powder in a first solvent to obtain a polyimide-based resin solution, dispersing the filler 120 in a second solvent to prepare a filler dispersion, and mixing the filler dispersion with the polyimide-based resin solution to prepare a first mix solution.

DMAc (N,N-dimethylacetamide) may be used as the first solvent. DMAc (N,N-dimethylacetamide) or methyl ethyl ketone (MEK) may be used as the second solvent, but one embodiment of the present disclosure is not limited thereto, and other known solvents as the first solvent and the second solvent may be used.

The fiber-shape filler 120, for example, a fiber-shape filler 120 having a high aspect ratio has a great length compared to the diameter thereof and thus may readily aggregate or agglomerate in the light-transmitting matrix. Therefore, the filler 120 requires excellent dispersibility in the first mix solution.

According to one embodiment of the present disclosure, to improve the dispersibility of the filler 120, for example, p-toluene sulfonic acid (PTSA) may be used as an additive, but one embodiment of the present disclosure is not limited thereto and other known additives may be used to improve the dispersibility of the filler 120.

According to one embodiment of the present disclosure, in order to improve the dispersibility of the filler 120, the pH of the first mix solution may be adjusted. For example, the pH of the first mix solution may be adjusted to the range of 5 to 7. Accordingly, aggregation or agglomeration of the filler 120 may be prevented.

Next, the first mix solution is cast, dried and heat-treated to form an optical film 100. According to one embodiment of the present disclosure, the film formed by casting the first mix solution may be referred to as a "cast film" and the film produced by drying and heat-treating the cast film may be referred to as an "optical film 100". The cast film can be referred to as an "uncured film".

In order to improve the orientation of the filler 120, casting may be performed by bar coating.

According to one embodiment of the present disclosure, the orientation direction and degree of the filler 120 may be varied by adjusting the pressure applied to the cast film formed by casting. The pressure applied to the cast film is such that Mm/Mt is greater than 1.

By controlling the pressure applied to the cast film, the orientation direction and degree of the filler 120 are adjusted. As a result, Mm/Mt is greater than 1, so that the modulus of the resulting optical film 120 can be greatly improved.

According to one embodiment of the present disclosure, a pressure enabling Mm/Mt to be 1.1 or more may be

applied to the cast film. Specifically, a pressure enabling Mm/Mt to be 1.25 or more may be applied to the cast film, and more specifically, a pressure enabling Mm/Mt to be 2.5 or more may be applied to the cast film.

In addition, convection may be prevented during drying and heat treatment of the cast film formed by casting, so that the filler 120 may be oriented in a certain direction.

Specifically, when convection is generated inside the cast film that is dried using heat, the orientation of the filler 120 may decrease. Thus, the cast film may be allowed to be dried slowly to prevent convection. For example, drying of the cast film may be performed while raising the temperature from 80°C to 120°C at a rate of 1°C/1 minute. When drying is performed over a certain level, the orientation of the filler 120 may be fixed.

Hereinafter, the present disclosure will be described in more detail with reference to preparation examples and examples. However, the following preparation examples and examples should not be construed as limiting the scope of the present disclosure.

<Preparation Example 1: Preparation of polymer-imide-based polymer solid>

776.655 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C, 54.439 g (0.17 mol) of bis(trifluoromethyl)benzidine (TFDB) was dissolved therein and the temperature of the solution was maintained at 25°C. 15.005 g (0.051 mol) of biphenyltetracarboxylic acid dianhydride (BPDA) was further added thereto and completely dissolved therein by stirring for 3 hours, and 22.657 g (0.051 mol) of 4,4'-(hexafluoroisopropylidene)diphthalic anhydride (6FDA) was further added thereto and completely dissolved therein. The reactor temperature was lowered to 10°C, and 13.805 g (0.068 mol) of terephthaloyl chloride (TPC) was further added thereto and allowed to react at 25°C for 12 hours to obtain a polymer solution having a solid content of 12 wt%.

17.75 g of pyridine and 22.92 g of acetic anhydride were added to the obtained polymer solution, stirred for 30 minutes, stirred again for 1 hour at 70°C, and allowed to cool to room temperature. 20L of methanol was added to the obtained polymer solution to precipitate a solid and the precipitated solid was filtered, pulverized, washed with 2L of methanol, and dried under vacuum at 100°C for 6 hours to prepare a polyimide-based polymer solid as a powder. The prepared polyimide-based polymer solid was a polyamide-imide polymer solid.

<Example 1>

850 g of DMAc (first solvent) was added to a 1 L reactor and the reactor was stirred for a certain period of time while the temperature of the reactor was maintained at 10°C. Then, 127 g of polyamide-imide (polyimide-based resin powder) prepared as the solid powder in Preparation Example 1 was added to the reactor, stirred for 1 hour, and heated to 25°C to prepare a liquid polyimide-based resin solution.

An alumina fiber dispersion was used as the dispersion added to the filler 120. Specifically, the alumina fiber dispersion used herein was an alumina fiber dispersion in which alumina fibers having an average particle diameter of about 4 nm and an average length of about 1,600 nm were dispersed in an amount of 10% by weight in a DMAc (N,N-dimethylacetamide, second solvent) solution. The content of the filler 120 was adjusted to 10% by weight based on the total weight of the solid (polyimide-based resin component + filler).

Specifically, another 1L reactor was filled with the alumina fiber dispersion, the temperature of the reactor was maintained at 25°C, and the prepared liquid polyimide-based resin solution was slowly added thereto for 1 hour using a cylinder pump to obtain a first mix solution containing the alumina fiber dispersion and the polyimide-based resin solution. Here, the filler 120 was an alumina fiber represented by Formula 9.

The pH of the first mix solution was 8 or higher when measured immediately after preparing the first mix solution. In order to improve the alignment characteristics of the filler 120, a weak acid such as acetic acid was added to the first mix solution to adjust the pH of the first mix solution to be within the range of 5 to 7. The first mix solution thus prepared was a polyimide-based resin solution in which the fiber-shape filler 120 was dispersed.

The obtained first mix solution was cast. A casting substrate was used for casting. At this time, there is no particular limitation on the type of the casting substrate. The casting substrate may be a glass substrate, a stainless steel (SUS) substrate, a Teflon substrate, or the like. According to one embodiment of the present disclosure, a glass substrate was used as the casting substrate.

Specifically, the obtained first mix solution was applied to a glass substrate and cast. In order to improve the orientation of the filler 120, the first mix solution was applied to the glass substrate (casting substrate) and cast while applying a force of 30 N in a direction perpendicular to the glass substrate. As a result, a cast film was produced.

Specifically, the cast film was produced by slowly drying in a hot air oven at 80°C up to 120°C at a rate of 1°C/min for about 40 minutes to maintain the orientation of the filler 120. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes.
As a result, an optical film 100 having a thickness of 50 μm and including the light-transmitting matrix 110 and the filler 120 dispersed in the light-transmitting matrix was completed.

<Examples 2 to 11>

The optical films 100 were produced under the conditions of Table 1 in the same manner as in Example 1 and were respectively referred to as "Examples 2 to 11".

<Comparative Examples 1 to 6>

The optical films 100 were produced under the conditions of Table 1 in the same manner as in Example 1, except that pressing and drying conditions were changed, and were respectively referred to as "Comparative Examples 1 to **6".**

<Comparative Example 7>

The optical film 100 was produced under the conditions of Table 1 in the same manner as in Example 1, except that weak acid addition, pressing and drying conditions were changed, and was referred to as "Comparative Example 7".
In Comparative Example 7, the cast film was put in a hot air oven at 120°C and dried for 30 minutes to produce a film, and after peeling, the film was fixed to the frame with pins.

<Reference Example 1>

An optical film 100 was produced under the conditions of Table 1 in the same manner as in Example 1, except that a weak acid was added to the first mixed solution, and this was referred to as "Reference Example 1".

<Reference example 2>

An optical film 100 was produced under the conditions of Table 1 in the same manner as in Example 1, except that pressing and drying conditions were changed, and this was referred to as "Reference Example 2".

[Table 1]

| Item | Type of filler | Content of filler (wt%) | Length/diam eter of filler | Weak acid addition (dispersi bility) | Pressing, drying (orientatio n) |
|---|---|---|---|---|---|
| Example 1 | Alumina | 10 | 400 (1600/4) | O | O |
| Example 2 | Alumina | 1 | 400 (1600/4) | O | O |
| Example 3 | Alumina | 5 | 400 (1600/4) | O | O |
| Example 4 | Alumina | 20 | 400 (1600/4) | O | O |
| Example 5 | Alumina | 30 | 400 (1600/4) | O | O |
| Example 6 | Alumina | 40 | 400 (1600/4) | O | O |
| Example 7 | Alumina | 10 | 50 (200/4) | O | O |
| Example 8 | Alumina | 10 | 100 (400/4) | O | O |
| Example 9 | Alumina | 10 | 200 (800/4) | O | O |
| Example 10 | Alumina | 10 | 300 (1200/4) | O | O |
| Example 11 | Alumina | 10 | 500 (2000/4) | O | O |
| Comparative Example 1 | Not -added | - | - | O | O |
| Comparative Example 2 | Alumina | 10 | 1 (10/10) | O | O |
| Comparative Example 3 | Silica | 10 | 1 (10/10) | O | O |

(continued)

| Item | Type of filler | Content of filler (wt%) | Length/diam eter of filler | Weak acid addition (dispersi bility) | Pressing, drying (orientatio n) |
|---|---|---|---|---|---|
| Comparative Example 4 | Alumina | 50 | 400 (1600/4) | O | O |
| Comparative Example 5 | Alumina | 10 | 5 (20/4) | O | O |
| Comparative Example 6 | Alumina | 10 | 600 (2400/4) | O | O |
| Comparative Example 7 | Alumina | 10 | 400 (1600/4) | X | X |
| Reference Example 1 | Alumina | 10 | 400 (1600/4) | X | O |
| Reference Example 2 | Alumina | 10 | 400 (1600/4) | O | X |
| Unit of the length and diameter of the filler 120: nm<br>Weak acid: acetic acid<br>Alumina: alumina fiber dispersion | | | | | |

<Measurement example>

The following measurements were performed on the optical films produced in Examples 1 to 11, Comparative Examples 1 to 7, and Reference Examples 1 and 2.

(1) Measurement of modulus

The modulus of each of the optical films produced according to Examples 1 to 11, Comparative Examples 1 to 7, and Reference Examples 1 and 2 was measured using an universal tensile tester (MODEL 5967) from Instron Corporation in accordance with ASTM D885.

- Criteria of measurement within three hours after film production
- Load Cell 30 KN, Grip 250N.
- Specimen size: 10 mm × 100 mm, tensile speed: 25 mm/min
- Because orientation is created in the direction of coating, the coating direction is called "MD", the direction orthogonal to coating is called "TD", and the measurement was performed in the two directions.

(2) Measurement of Vickers hardness (Hv)

The hardness of the surface area of the marks formed by pressing with a diamond quadrangular pyramid with a diagonal angle of 136 degrees is measured in accordance with ISO 14577-1. Hv = C/D is calculated when the pressing load is C kg and the surface area is D $mm^2$. The Vickers hardness (Hv) of each of the optical films produced according to Examples 1 to 11, Comparative Examples 1 to 7, and Reference Examples 1 and 2 was measured using HM-2000 from Fisher Measurement Technologies.

(3) Measurement of yellowness index (Y.I.)

The yellowness index of each of the optical films produced according to Examples 1 to 11, Comparative Examples 1 to 7, and Reference Examples 1 and 2 was measured using a spectrophotometer (CM-3700D, KONICA MINOLTA) in accordance with the ASTM E313 standard.

(4) Measurement of haze

The haze of each of the optical films produced according to Examples 1 to 11, Comparative Examples 1 to 7, and Reference Examples 1 and 2 was measured by cutting the optical film into specimens with a size of 50 mm × 50 mm, measuring the haze of each specimen 5 times using a haze meter, for example, a haze meter from Murakami Color Laboratories (model name: HM-150) in accordance with ASTM D1003, and calculating an average of the measured five haze values.

(5) Measurement of light transmittance (%)

The average light transmittance at a wavelength of 360 to 740 nm of each of the optical films produced according to Examples 1 to 11, Comparative Examples 1 to 7, and Reference Examples 1 and 2 was measured using a spectrophotometer (CM-3700D, KONICA MINOLTA).

(6) Folding marks

A 100 mm × 50 mm sample randomly obtained from each of the optical films produced in accordance with Examples 1 to 11, Comparative Examples 1 to 7, and Reference Examples 1 and 2 was subjected to a bending test along one bending axis. The bending test was performed by repeatedly bending the sample with a size of 100 mm × 50 mm 200,000 times at a speed of 60 rpm with a radius of curvature of 2.0 mm (diameter 4.0 mm) at 25°C/50 RH% using a bending test machine (YUASA, DLDM111LHA). Then, whether or not folding marks were formed based on the bending axis was determined. The case where folding marks such as cracking or whitening occurred was marked as "O" and the case where folding marks did not occur was marked as "X".

At this time, an analysis method for sharpening the contrast (shading) of the folding marks may be required. For example, imaging may be performed by inspecting foreign material on the film. If possible, various inspection methods such as reflection, scattering, and transmission methods are used to detect defects or dents that are difficult to perceive using a CCD camera or the naked eye, in order to detect foreign matter having the same color as the material for the film. Preferred is the use of an inspection (i.e., determination) device rather than a measurement device.

Specifically, for example, the inspection device includes three components, namely, an inspection device, a control unit (controller box: converts laser data received through the inspection device into image data) and a dedicated PC (imaging PC: a PC having installed thereon a dedicated application, which is connected to the control unit (controller box) and is capable of performing image processing). That is, the analysis/evaluation may be performed by setting measurement/evaluation conditions, converting laser data into image data, and conducting analysis using known software for analyzing the brightness, saturation, reflectivity, etc. of the image/photo, but is not limited thereto.

(7) Electrical insulation (surface resistance)

In order to determine the electrical insulation properties of the optical films produced according to Examples 1 to 11, Comparative Examples 1 to 7, and Reference Examples 1 and 2, the surface resistance of each optical film was measured using an MCP-HT450 from Mitsubishi Chemical Corporation. The measurement range of the surface resistance of the measuring device is $1\times10^{15}$ Ω/□ or less, and measurement was impossible when the surface resistance was higher than $1\times10^{15}$ Ω/□. The measurement range of the measuring device caused surface resistance and the case where it was impossible to measure the surface resistance of the optical film 100 is indicated by "N.D.".

(8) Measurement of degree of orientation of filler

1) The degree of orientation in the MD of each of the optical films produced according to Examples 1 to 11, Comparative Examples 1 to 7, and Reference Examples 1 and 2 was measured using an FT-IR spectrometer as follows.
2) Device and measurement conditions

- FT-IR spectrometer: PerkinElmer spectrum 100
- Veemax III with ATR and 45 degree ZnSe crystal
- Incident angle: 80 degrees (air to crystal), polarization angle: 0 degrees

3) Measurement of absorbance and correction value in MD

FT-IR in the MD of the optical film 100 is measured to measure the absorbance of the filler 120 in the MD. At this time, the optical film 100 is irradiated with light polarized in the TD. Light polarized in the TD is radiated to measure the absorbance of the filler 120 in the MD since the Al-O stretching direction of the filler 120 is perpendicular to the longitudinal direction of the filler 120.

FT-IR measurements in the MD of the optical film 100 are performed on the first surface (S1, belt surface) and the second surface (S2, air surface). As a result, for example, an FT-IR graph as shown in FIG. 4 can be obtained.

$AlO_{MD}$ and $Ref_{MD}$ can be obtained from the measurement results and graphs.

[Equation 1]

$$AlO_{MD} = A(760\ cm^{-1}) - A(869\ cm^{-1});\ (MD)$$

An absorbance correction value ($A_{MD}$) in the MD was obtained from the $AlO_{MD}$ calculated in Equation 1 and the $Ref_{MD}$ obtained from the FT-IR graph (see FIG. 4). The absorbance correction value in the MD was calculated in accordance with Equation 2 below. According to one embodiment of the present disclosure, $A_{MD}$ in Equation 2 is referred to as "absorbance correction value in MD".

[Equation 2]

$$A_{MD} = AlO_{MD}/Ref_{MD}$$

4) Measurement of absorbance and correction value in TD

FT-IR in the TD of the optical film 100 is measured to measure the absorbance of the filler 120 in the TD. At this time, the optical film 100 is irradiated with light polarized in the MD. Light polarized in the MD is radiated to measure the absorbance of the filler 120 in the TD since the Al-O stretching direction of the filler 120 is perpendicular to the longitudinal direction of the filler 120.

FT-IR measurements in the TD of the optical film 100 are performed on the first surface (S1, belt surface) and the second surface (S2, air surface). As a result, for example, an FT-IR graph as shown in FIG. 4 can be obtained.

$AlO_{TD}$ and $Ref_{TD}$ can be obtained from the measurement results and graphs.

[Equation 3]

$$AlO_{TD} = A(760cm^{-1}) - A(869cm^{-1});\ (TD)$$

An absorbance correction value ($A_{TD}$) in the TD is obtained from the $AlO_{TD}$ calculated in Equation 3 and the $Ref_{TD}$ obtained from the FT-IR graph (see FIG. 4). The absorbance correction value in the TD is calculated in accordance with Equation 4 below. According to one embodiment of the present disclosure, $A_{TD}$ in Equation 4 is referred to as "absorbance correction value in TD".

[Equation 4]

$$A_{TD} = AlO_{TD}/Ref_{TD}$$

5) Degree of orientation in MD

From the absorbance correction value ($A_{MD}$) in the MD calculated in Equation 2 and the absorbance correction value ($A_{TD}$) in the TD calculated in Equation 4, the degree of orientation of the optical film 100 in the MD is calculated in accordance with Equation 5.

[Equation 5]

$$\text{Degree of MD orientation (\%)} = [A_{MD} / (A_{MD} + A_{TD})] \times 100$$

The results of measurement of physical properties are shown in Tables 2 and 3 below.

[Table 2]

| Item | Modulus (GPa) | | | Mm/Mt | Foldability (Folding marks) | Degree of orientation (%, MD) | | |
|---|---|---|---|---|---|---|---|---|
| | MD | TD | Average | | | Air surface | Belt surface | Average |
| Example 1 | 9.5 | 7.1 | 8.3 | 1.34 | X | 83 | 79 | 81 |

(continued)

| Item | Modulus (GPa) | | | Mm/Mt | Foldabil ity (Folding marks) | Degree of orientation (%, MD) | | |
|---|---|---|---|---|---|---|---|---|
| | MD | TD | Average | | | Air surface | Belt surface | Average |
| Example 2 | 6.9 | 6.2 | 6.6 | 1.11 | X | 66 | 62 | 64 |
| Example 3 | 8.2 | 7.3 | 7.8 | 1.12 | X | 74 | 70 | 72 |
| Example 4 | 11.9 | 8.3 | 10.1 | 1.43 | X | 85 | 83 | 84 |
| Example 5 | 12.8 | 8.7 | 10.8 | 1.47 | X | 86 | 83 | 85 |
| Example 6 | 13.5 | 9.0 | 11.3 | 1.50 | X | 88 | 84 | 86 |
| Example 7 | 7.9 | 7.9 | 7.9 | 1.03 | X | 63 | 60 | 62 |
| Example 8 | 8.1 | 7.6 | 7.9 | 1.07 | X | 75 | 69 | 72 |
| Example 9 | 8.6 | 7.5 | 8.1 | 1.15 | X | 79 | 74 | 77 |
| Example 10 | 9.3 | 7.3 | 8.3 | 1.27 | X | 83 | 78 | 81 |
| Example 11 | 9.5 | 7.3 | 8.4 | 1.30 | X | 84 | 78 | 81 |
| Comparat ive Example 1 | 5.0 | 4.9 | 5.0 | 1.02 | X | - | - | - |
| Comparat ive Example 2 | 5.8 | 5.9 | 5.9 | 0.98 | X | 54 | 53 | 54 |
| Comparat ive Example 3 | 5.9 | 6.2 | 6.1 | 0.95 | X | 55 | 51 | 53 |
| Comparat ive Example 4 | 13.2 | 9.2 | 11.2 | 1.43 | O | 94 | 91 | 93 |
| Comparative Example 5 | 7.6 | 7.4 | 7.5 | 1.03 | X | 60 | 56 | 58 |
| Comparat ive Example 6 | 9.4 | 7.2 | 8.3 | 1.31 | O | 93 | 90 | 92 |
| Comparat ive Example 7 | 7.9 | 7.8 | 7.9 | 1.01 | X | 55 | 52 | 54 |
| Referenc e Example 1 | 9.0 | 7.5 | 8.3 | 1.20 | O | 82 | 79 | 81 |
| Referenc e Example 2 | 7.6 | 7.7 | 7.7 | 0.99 | X | 52 | 53 | 53 |

[Table 3]

| Item | Vickers hardness (MPa) | Yellowness index | Haze (%) | Light transmittance (%) | Surface resistance (Ω) |
|---|---|---|---|---|---|
| Example 1 | 44.8 | 2.80 | 0.2 | 89.1 | N.D. |
| Example 2 | 41.5 | 2.75 | 0.1 | 89.0 | N.D. |
| Example 3 | 41.9 | 2.82 | 0.2 | 88.9 | N.D. |
| Example 4 | 45.0 | 2.79 | 0.2 | 89.2 | N.D. |
| Example 5 | 45.3 | 2.77 | 0.3 | 89.4 | N.D. |
| Example 6 | 45.6 | 2.79 | 0.4 | 89.3 | N.D. |
| Example 7 | 43.0 | 2.80 | 0.3 | 89.1 | N.D. |
| Example 8 | 42.7 | 2.81 | 0.2 | 89.1 | N.D. |
| Example 9 | 43.4 | 2.83 | 0.2 | 89.2 | N.D. |
| Example 10 | 44.5 | 2.81 | 0.3 | 88.9 | N.D. |
| Example 11 | 44.7 | 2.79 | 0.5 | 88.6 | N.D. |
| Comparative Example 1 | 41.3 | 2.85 | 0.2 | 89.2 | N.D. |
| Comparative Example 2 | 40.8 | 2.93 | 0.4 | 88.6 | N.D. |
| Comparative Example 3 | 41.1 | 2.83 | 0.2 | 88.9 | N.D. |

(continued)

| Item | Vickers hardness (MPa) | Yellowness index | Haze (%) | Light transmittance (%) | Surface resistance (Ω) |
|---|---|---|---|---|---|
| Comparative Example 4 | 41.5 | 2.79 | 0.2 | 89.0 | N.D. |
| Comparative Example 5 | 44.4 | 2.90 | 0.3 | 89.0 | N.D. |
| Comparative Example 6 | 44.4 | 2.80 | 0.2 | 89.3 | N.D. |
| Comparative Example 7 | 44.2 | 3.30 | 0.9 | 88.5 | N.D. |
| Reference Example 1 | 44.1 | 3.41 | 1.2 | 89.1 | N.D. |
| Reference Example 2 | 42.5 | 2.86 | 0.2 | 89.2 | N.D. |

Regarding the surface resistance, "N.D" means that measurement is impossible because the surface resistance $1X10^{15}$ Ω/□ is higher than the measurement limit of the measuring device.

As can be seen from the results of measurement shown in Tables 2 and 3, the optical film 100 according to the embodiments of the present disclosure has excellent modulus and mechanical strength, and does not impair other optical properties such as light transmittance, yellowness index, and haze.

In addition, it can be seen that the optical film 100 according to an embodiment of the present disclosure has excellent foldability as well as excellent modulus.

[Explanation of reference numerals]

100: Optical film
110: Light-transmitting matrix
120: Filler
200: Display device
501: Display panel

**Claims**

1. An optical film comprising:

   a light-transmitting matrix; and
   a filler dispersed in the light-transmitting matrix,
   wherein the filler has a fiber-shape and has a ratio of B/A of 10 to 500 wherein A represents a diameter of the filler and B represents a length of the filler.

2. The optical film according to claim 1, wherein the ratio of B/A is 100 to 400.

3. The optical film according to claim 1, wherein the ratio of B/A is 200 to 400.

4. The optical film according to claim 1, wherein the filler has a diameter of 2 nm to 10 nm and a length of 200 nm to 4,000 nm.

5. The optical film according to claim 1, wherein the filler comprises at least one of a glass fiber, an aluminum fiber, and a fluoride fiber.

6. The optical film according to claim 1, wherein the filler comprises at least one of aluminum oxide hydroxide, $SiO_2$, $Al_2O_3$, PTFE (polytetrafluoroethylene), or PVDF (polyvinylidene fluoride).

7. The optical film according to claim 1, wherein the filler is present in an amount of 1 to 40% with respect to a total weight of the optical film.

**8.** The optical film according to claim 1, wherein the optical film has a modulus of 6.3 GPa or more based on a sample with a size of 10 cm x 1 cm.

**9.** The optical film according to claim 1, wherein the optical film has a ratio of Mm/Mt greater than 1,

wherein Mm represents a modulus in a machine direction (MD) and Mt represents a modulus in a transverse direction (TD),
wherein the machine direction (MD) is a direction parallel to the casting direction of the optical film in a manufacturing process of the optical film and the transverse direction (TD) is a direction perpendicular to the machine direction (MD).

**10.** The optical film according to claim 9, wherein the ratio of Mm/Mt is 1.10 or more.

**11.** The optical film according to claim 9, wherein the ratio of Mm/Mt is 1.25 or more.

**12.** The optical film according to claim 1, wherein the filler has a degree of machine direction (MD) orientation of 60 to 90%,

wherein the machine direction (MD) is a direction parallel to the casting direction of the optical film in a manufacturing process of the optical film, and
the degree of machine direction (MD) orientation is measured in accordance with the following conditions:

- FT-IR spectrometer: PerkinElmer spectrum 100
- Veemax III with ATR and 45 degree ZnSe crystal
- Incident angle: 80 degrees (air to crystal), polarization angle: 0 degrees.

**13.** The optical film according to claim 1, wherein the optical film has electrical insulation property.

**14.** The optical film according to claim 13, wherein the optical film has an electrical resistance of 1 X $10^{10}$ Ω/□ or more.

**15.** The optical film according to claim 1, wherein the optical film has a Vickers hardness (Hv) of 40 MPa or more.

**16.** The optical film according to claim 1, wherein the optical film has a yellowness index of 3 or less.

**17.** The optical film according to claim 1, wherein the optical film has a haze of 4% or less.

**18.** The optical film according to claim 1, wherein the optical film has a light transmittance of 88% or more.

**19.** The optical film according to claim 1, wherein the light-transmitting matrix comprises at least one of an imide repeating unit or an amide repeating unit.

**20.** A display device comprising:

a display panel; and
the optical film according to any one of claims 1 to 19 disposed on the display panel.

**21.** A method of manufacturing an optical film comprising:

primarily dispersing a filler in a resin solution for forming a polymer matrix to prepare a first mix solution;
adjusting a pH of the first mix solution to 5 to 7 to improve alignment characteristics of the filler;
casting the first mixture solution to produce a cast film;
applying a pressure to the cast film; and
drying the cast film while raising the temperature from 80°C to 120°C at a temperature elevation rate of 1°C/1 minute,
wherein the filler has a fiber-shape and has a ratio of B/A of 10 to 500, wherein A represents a diameter of the filler and B represents a length of the filler.

FIG. 1

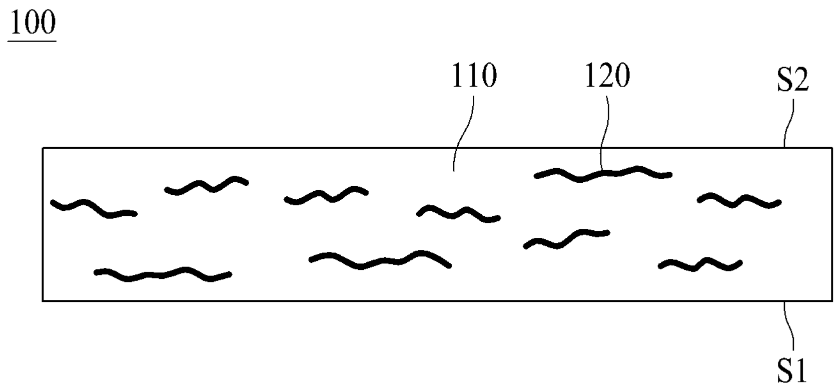


FIG. 2

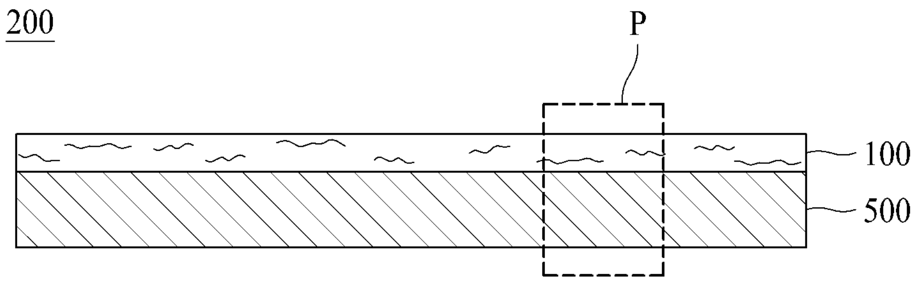

FIG. 3

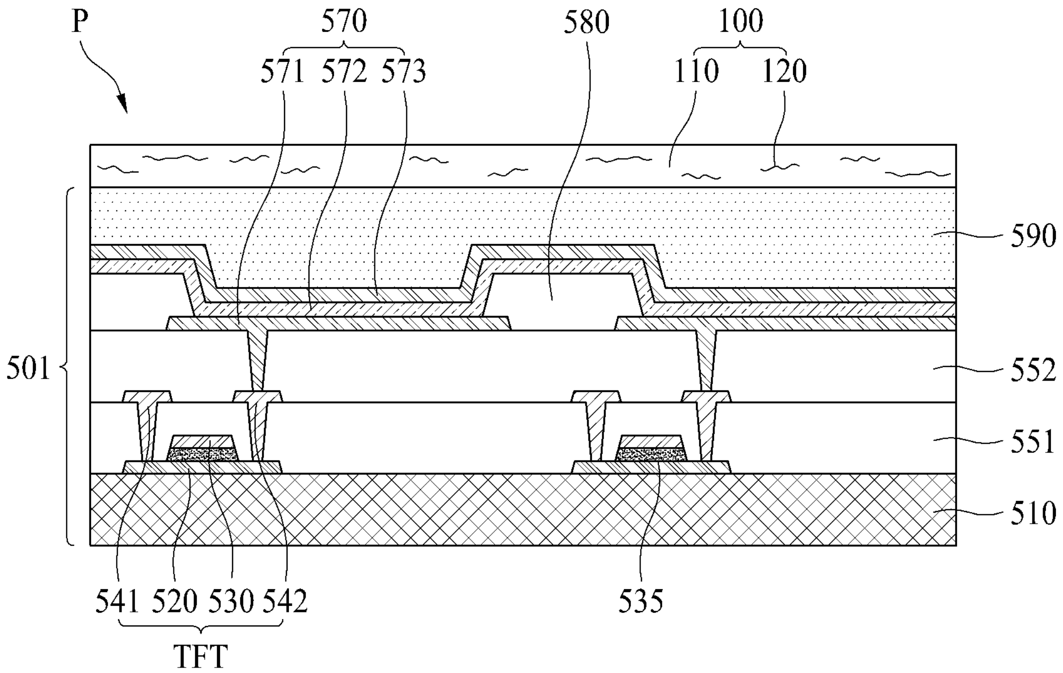
P
570
571 572 573
580
100
110 120
590
501
552
551
510
541 520 530 542
TFT
535

FIG. 4

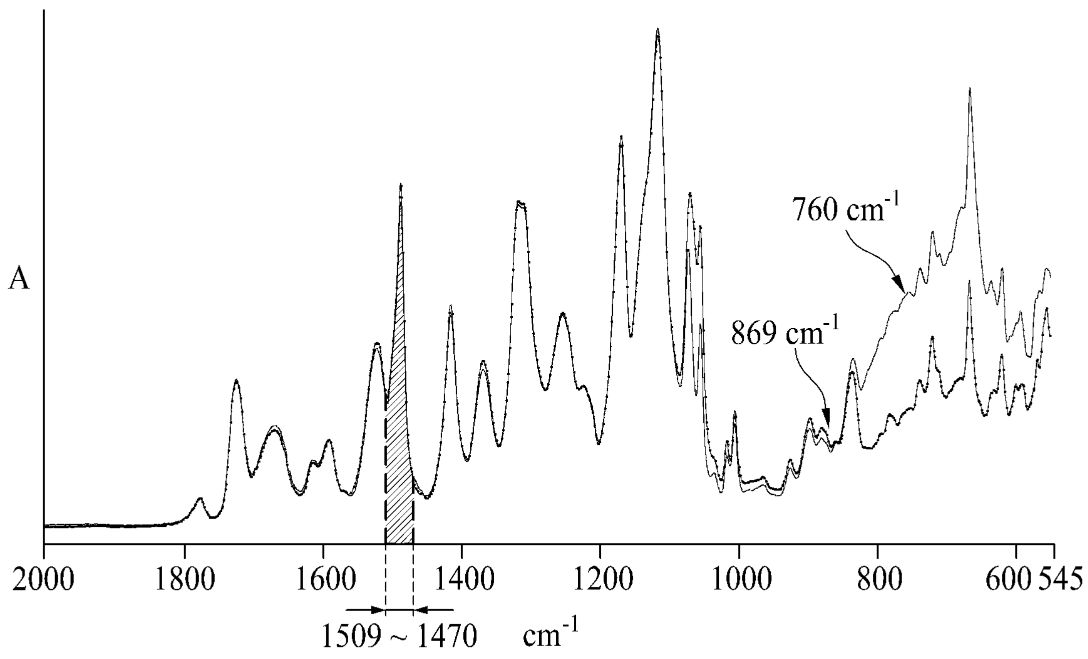
A
760 cm-1
869 cm-1
2000
1800
1600
1400
1200
1000
800
600 545
1509 ~ 1470
cm-1

## INTERNATIONAL SEARCH REPORT

International application No.
**PCT/KR2023/010253**

**A. CLASSIFICATION OF SUBJECT MATTER**

**G02B 5/20**(2006.01)i; **C08J 5/18**(2006.01)i; **C08K 7/02**(2006.01)i; **G09F 9/30**(2006.01)i; **H10K 59/00**(2023.01)i; **G02F 1/1335**(2006.01)i; **G09F 9/00**(2006.01)i; **H10K 50/00**(2023.01)i

According to International Patent Classification (IPC) or to both national classification and IPC

**B. FIELDS SEARCHED**

Minimum documentation searched (classification system followed by classification symbols)

G02B 5/20(2006.01); B32B 5/28(2006.01); C08B 37/08(2006.01); C08G 69/26(2006.01); C08J 5/04(2006.01); C08J 5/08(2006.01); C08J 5/18(2006.01); F21V 7/00(2006.01); G02B 5/02(2006.01); G02F 1/1333(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 광학필름(optical film), 매트릭스(matrix), 필러(filler), 섬유(fiber), 직경(diameter), 길이(length)

**C. DOCUMENTS CONSIDERED TO BE RELEVANT**

| Category* | Citation of document, with indication, where appropriate, of the relevant passages | Relevant to claim No. |
|---|---|---|
| X<br>Y | KR 10-2014-0076892 A (GL KOREA CO., LTD.) 23 June 2014 (2014-06-23)<br>See paragraphs [0018]-[0025] and figures 1-2. | 1-5,7,12,21<br>6,8-11,13-20 |
| Y | KR 10-2022-0057341 A (SKC CO., LTD.) 09 May 2022 (2022-05-09)<br>See paragraphs [0002]-[0388]. | 6,8-11,13-20 |
| A | KR 10-2011-0089673 A (LG DISPLAY CO., LTD.) 09 August 2011 (2011-08-09)<br>See paragraphs [0010]-[0035] and figures 1-4. | 1-21 |
| A | JP 2012-062457 A (TOTTORI UNIV. et al.) 29 March 2012 (2012-03-29)<br>See paragraphs [0010]-[0092]. | 1-21 |
| A | JP 2017-149116 A (NITTO BOSEKI CO., LTD.) 31 August 2017 (2017-08-31)<br>See paragraphs [0005]-[0056]. | 1-21 |

☐ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 October 2023** | **26 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/010253**

| Patent document cited in search report | Publication date (day/month/year) | Patent family member(s) | Publication date (day/month/year) |
|---|---|---|---|
| KR 10-2014-0076892 A | 23 June 2014 | None | |
| KR 10-2022-0057341 A | 09 May 2022 | CN 116323756 A | 23 June 2023 |
| | | EP 4223832 A1 | 09 August 2023 |
| | | JP 2023-541166 A | 28 September 2023 |
| | | KR 10-2301581 B1 | 13 September 2021 |
| | | WO 2022-071675 A1 | 07 April 2022 |
| KR 10-2011-0089673 A | 09 August 2011 | None | |
| JP 2012-062457 A | 29 March 2012 | JP 5700283 B2 | 15 April 2015 |
| JP 2017-149116 A | 31 August 2017 | None | |

Form PCT/ISA/210 (patent family annex) (July 2022)